# EUROPEAN PATENT SPECIFICATION

(11) **EP 1 923 910 B1**
(45) Date of publication and mention of the grant of the patent: **13.06.2018**
(21) Application number: 07119093.8
(22) Date of filing: 23.10.2007
(51) Int. Cl.: H01L 21/3065

(54) **Selective removal of rare earth comprising materials in a semiconductor device**
Selektive Entfernung von seltenerdenenthaltenden Stoffen in einer Halbleitervorrichtung
Élimination sélective de matériaux comprenant des terres rares dans un dispositif semi-conducteur

(30) Priority: 23.10.2006 US 853895 P; 22.06.2007 US 945864 P
(43) Date of publication of application: 21.05.2008
(73) Proprietor: IMEC VZW, 3001 Leuven (BE)
(72) Inventor: Shamiryan, Denis, 3001 Leuven (BE); Demand, Marc, 1370 Saint-Jean-Geest (BE); Paraschiv, Vasile, 3010 Kessel-Lo (BE)
(74) Representative: Pronovem

(56) References cited:
- EP-A- 1 780 780
- WO-A-2008/112263
- US-A1- 2006 183 277
- US-B1- 6 764 898
- BECKX S ET AL: "Implementation of high-k and metal gate materials for the 45nm node and beyond: gate patterning development" MICROELECTRONICS AND RELIABILITY, ELSEVIER SCIENCE LTD, GB, vol. 45, no. 5-6, 1 May 2005 (2005-05-01), pages 1007-1011, XP004779607 ISSN: 0026-2714
- DEMAND M ET AL: "Dry etch of Yb-doped polys-Si gates for low Vt FUSI devices", 1ST INTERNATIONAL WORKSHOP ON PLASMA ETCH AND STRIP IN MICROELECTRONICS, 10-11 SEPTMEBER 2007, LEUVEN, BELGIUM, PRESENTATION AND ABSTRACT,, [Online] 10 September 2007 (2007-09-10), pages 1-24, XP002530204, Retrieved from the Internet: URL:http://www.pesm2007.be/05_02_demand.pd f>

## Description

### FIELD OF THE INVENTION

The present invention is related to the field of semiconductor processing. More specifically it is related to the selective removal of rare earth based high-k layers, more specifically to a rare earth scandate or rare earth oxide high-k material (e.g. DyScO₃ and/or Dy₂O₃).

The invention is further related to a method to make Dy and/or Sc comprising high-k materials (e.g. DyScO₃ and/or Dy₂O₃)soluble or in other words makes it possible to remove said materials by using a wet etching.

### BACKGROUND OF THE INVENTION

The semiconductor industry is facing the challenging task of finding a candidate to replace silicon oxide, which has been the CMOS gate dielectric of choice for more than 50 years. A material with a dielectric constant (k) higher than SiO₂ will allow making the dielectric thicker by a factor of k/k(SiO₂), hence lowering the gate current leakage levels, and this without reduction of the capacitance and thus performance.The k-value is, however, only one of a list of requirements that includes thermal and chemical stability, a wide bandgap, limited interfacial layer formation, a controllable etch behavior, correct and stable threshold voltage, and a good reliability (i.e. over a 10-year life time).

At present, the semiconductor industry's focus is on HfO₂ and HfSiOₓ, but parallel to the main stream development of HfO₂ and HfSiOₓ, material screening of alternate dielectrics continues. The interest in these alternative materials arises from the fact that several issues remain with the Hf-based dielectrics. Among the issues are, targeting the correct threshold voltage, the limited improvement in k-value for HfSiOₓ, and the necessity of nitridation to stabilize the material and prevent phase separation.

One class of materials being investigated and reported on are the rare earth based high-k materials such as rare earth scandate materials (REScCO₃). First results obtained by Pulsed Laser and E-Beam Deposition suggest that these materials have a k-value comparable to HfO₂ in combination with a high thermal stability.

Following deposition and gate patterning, the high-k dielectric material must be removed from the source and drain regions of the transistor. This removal must be accomplished without the loss of any of the underlying silicon, as well as little or no isolation oxide (field oxide) loss. In US6656852 a method is disclosed for etching a high-k dielectric. The method involves removing an exposed portion of a high-k dielectric layer from a substrate by wet etching with a solution comprising water, a strong acid, an oxidizing agent, and a fluorine compound. The etching solution provides selectivity towards the high-k film against insulating materials and poly-silicon however this method is not applicable to the rare earth scandate materials (REScOx) since these oxides are etched too fast and due to isotropic nature of wet etching an unacceptable undercut is formed under the gate.

The problem is removal of the rare earth based high-k dielectric selectively over the Si substrate and without making an undercut under the gate. Dry removal is impossible for these rare earth compounds since these compounds (e.g. Dy and Sc) form no volatile compounds. A wet removal is possible, but due to isotropic nature of wet etch it etches the high-k dielectric (e.g. DyScO₃) dielectric also laterally, creating an undercut at the gate edge beneath the gate.

The document US 2006/0183277 A1 discloses a method of patterning a high-k gate insulating structure comprising the steps of subjecting the exposed parts of the high-k layer to a Cl-comprising plasma and subsequently removing the Cl-treated layer in an acid.

### SUMMARY

The present invention provides a method particularly advantageous for removing at least part of rare earth comprising materials over a substrate underneath said material, and which does not have the drawbacks of the standard state of the art techniques.

The present invention also provides a method for selectively removing high-k materials comprising (or consisting of) rare earth metal oxides, and more specifically rare earth scandates, over silicon and silicon dioxide materials.

Furthermore, the present invention provides a method for patterning a gate structure comprising a gate electrode and a gate oxide layer using a combination of a dry etch plasma and a wet removal step, thereby avoiding undercut and lateral attack of the patterned gate structure.

The present invention provides a method for the manufacture of a semiconductor device as defined in claim 1.

In a method of the invention, the resulting chlorinated layer, more particularly the resulting chlorinated rare earth(s), dissolves in the water. In other words, the resulting chlorinated rare earth(s), being water soluble, are removed with water.

Preferably, said rare earth(s) is/are selected from the group consisting of Sc, Y, La, Pr, Nd, Gd, Tb, Dy, Ho, Er, Tm, Yb, and Lu. More preferably said rare earth (s) is/are Sc and/or Dy.

Preferably, said rare earth comprising layer consists of a rare earth oxide selected from the group consisting of Sc₂O₃, Y₂O₃, La₂O₃, Pr₂O₃, Nd₂O₃, Gd₂O₃, Tb₂O₃, Dy₂O₃, Ho₂O₃, Er₂O₃, Tm₂O₃, Yb₂O₃, and Lu₂O₃.

More preferably, said rare earth oxide is dysprosium oxide (Dy₂O₃).

Preferably, in a method according to the invention, said rare earth comprising layer consists of a rare earth scandate layer.

More particularly, said rare earth scandate is selected from the group consisting of LaScO₃, PrScO₃, NdScO₃, GdScO₃, TbScO₃, DyScO₃, HoScO₃, ErScO₃, TmScO₃, YbScO₃, and LuScO₃.

Most preferably, said rare earth scandate is dysprosium scandate (DyScO₃).

Preferably, in a method of the invention, said rare earth(s) comprising layer is a layer made substantially of rare earths (in particular of rare earth elements or rare earth oxides), more particularly made of more than 90%, preferably of more than 95%, more preferably of more than 95%, and even more preferably of more than 99%.

Preferably, in a method of the invention, said rare earth(s) comprising layer is deposited using any suitable deposition techniques known in the art.

More preferably, said rare earth(s) comprising layer is deposited by Atomic Vapor Deposition (AVD).

Preferably, in a method according to the invention, said substrate is not soluble in aqueous solutions or in water.

Preferably, in a method according to the invention, said plasma is anisotropically applied.

In an example said chlorination and a bromination can be performed sequentially, both orders being envisaged, or can be performed simultaneously.

In particular, the term "Cl-comprising plasma and/or Br-comprising plasma" also encompasses a Cl- and/or Br-comprising plasma.

More preferably, said Cl-comprising plasma is a Cl₂ and/or BCl₃ comprising plasma.

More preferably, said Br-comprising plasma is a Br₂ and/or a HBr comprising plasma.

In a method of the invention, said Cl- and/or Br-comprising plasma does not contain fluorine or fluorine containing compounds.

In a method of the invention, Cl and optionally Br is/are provided in a sufficient amount in said plasma for chlorinating and optionally brominating the compounds (i.e. rare earths) to be removed in the next step of contacting or rinsing with (or dipping in) water.

Inert compounds, such as argon, helium, and/or nitrogen can be added to said plasma.

In a method of the invention, said subjecting step and said contacting step can be repeated (at least once).

More particularly, said subjecting step and said contacting step can be repeated for the complete removal of said rare earth(s) comprising (or consisting of) layer, said removal being possibly limited to a delimited (or restricted) area. In particular, said plasma is preferably anisotropically applied, whereby a delimited area is chlorinated and optionally brominated.

Preferably, in a method according to the invention, the bias applied (to said substrate), during the step of subjecting said exposed rare earth(s) comprising layer, or said exposed part, to said (anisotropic) plasma, is -30V.

Preferably, in a method according to the invention, the plasma power during the step of subjecting said exposed rare earth(s) comprising layer, or said exposed part, to a Cl-comprising plasma and optionally a Br-comprising plasma, is in the range of 100W up to 1200W.

More preferably, said plasma power is around 450W.

Preferably, in a method according to the invention, the pressure in the plasma during the step of subjecting said exposed rare earth(s) comprising layer, or said exposed part, to a Cl-comprising plasma, is minimum 1.333Pa (lOmT) and maximum 10.665Pa (80mT).

Preferably, said pressure is 1.333Pa (10mT).

In the method according to the invention, said rare earth(s) comprising layer is used as high-k material (or a material having a dielectric constant, k, higher than the one of SiO₂).

A method according to the invention further comprises at least one other rare earth(s) comprising layer.

Preferably, a layer underneath said high-k layer comprising rare earth(s) is another rare earth(s) comprising layer.

Preferably, said rare earth(s) comprising layers do not react with each other. More particularly, said rare earth(s) comprising layers do not generate compounds that are not water soluble after chlorination and/or bromination.

More preferably, said high-k material is a rare earth oxide selected from at least one of the group consisting of Sc₂O₃, Y₂O₃, La₂O₃, Pr₂O₃, Nd₂O₃, Gd₂O₃, Tb₂O₃, Dy₂O₃, Ho₂O₃, Er₂O₃, Tm₂O₃, Yb₂O₃, and Lu₂O₃.

More preferably, said high-k material is a rare earth scandate material selected from at least one of the group consisting of LaScO₃, PrScO₃, NdScO₃, GdScO₃, TbScO₃, DyScO₃, HoScO₃, ErScO₃, TmScO₃, YbScO₃, and LuScO₃.

Most preferably, said high-k material is DyScO₃.

A method for the manufacture of a semiconductor device comprising selectively removing, at least partly, a layer comprising (or consisting of) rare earths over a substrate according to the invention, is used for patterning a (high-k) gate insulating structure in a semiconductor device.

In particular, a method for patterning a (high-k) gate insulating structure in a semiconductor device, comprises, after having deposited said high-k layer(s), and before said subjecting and contacting/rinsing steps, the steps of
- Depositing a gate electrode layer onto said high-k layer(s),
- Depositing photosensitive imaging layers and transferring a photolithographic pattern in said imaging layers to define the gate structure,
- Transferring said gate structure pattern into said gate electrode layer,
- Developing a mask structure to define a gate structure on said high-k layer(s) and expose parts of said high-k layer(s).

Preferably, said gate electrode layer is any suitable layer known from the skilled person in the art.

Preferably, in a method according to the invention, the step of subjecting said exposed parts of said high-k layer(s) is performed by an anisotropic dry-etch plasma.

More preferably, the step of subjecting said exposed parts of said high-k layer(s) and the step of patterning said gate electrode layer are simultaneous, using a Cl-comprising plasma and optionally a Br-comprising plasma whereby, during the etching, said exposed parts of said high-k layer (s) get chlorinated and optionally brominated.

More preferably, said gate electrode layer is a TaN, TiN, or TaN/TiN layer.

### SHORT DESCRIPTION OF THE DRAWINGS

All drawings are intended to illustrate some aspects and embodiments of the present invention. Not all alternatives and options are shown and therefore the invention is not limited to the content of the given drawings.

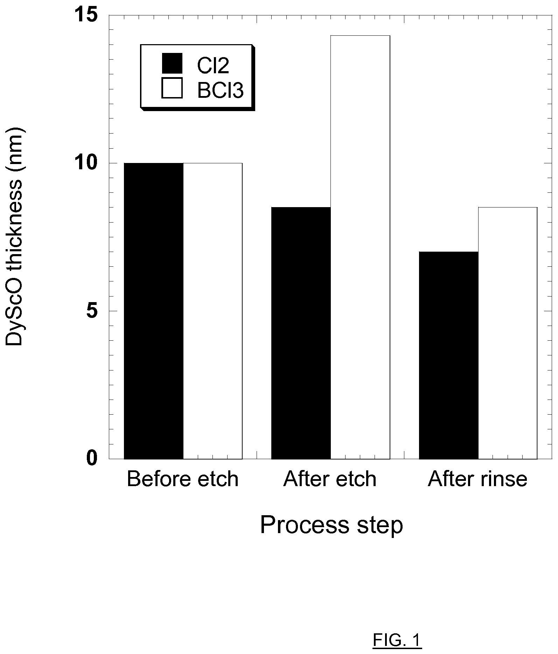

Figure 1 illustrates DyScO₃ thickness after the removal experiments using the method of the invention. The initial thickness is 10 nm, after exposure to Cl₂ plasma for 30 s about 1.5 nm is removed, probably due to physical sputtering. The BCl₃ plasma deposits as film on top (probably BxCly film), but does not result in the thickness decrease. Water rinse removes around 1.5 nm in the case of DyScO₃ exposure to Cl₂ (probably, the chlorinated layer) and around 5.5 nm in the case of BCl₃ exposure (BxCly film plus chlorinated DySCO₃). The thickness of DyScO₃ in real devices usually in the range of 2-4 nm.

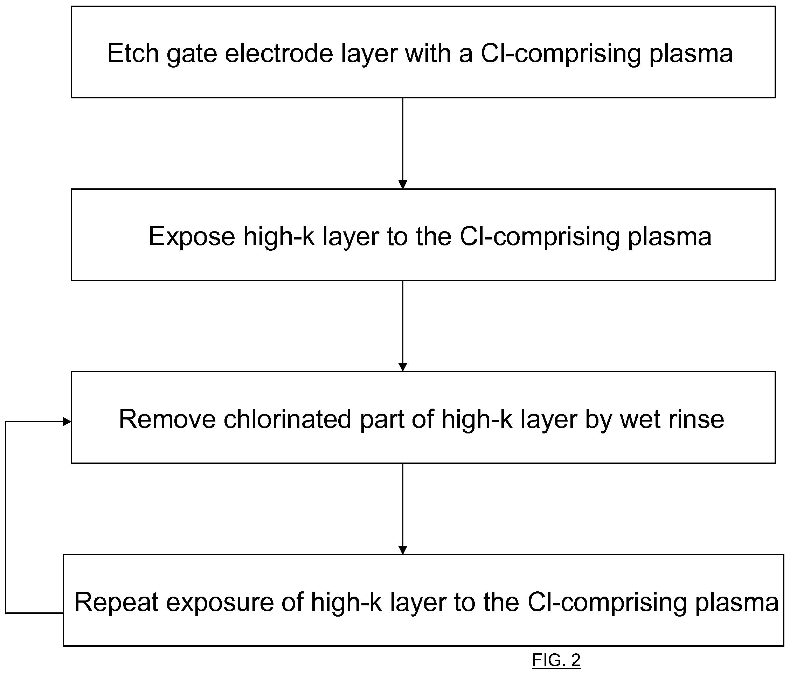

Figure 2 illustrates a flowchart according to a preferred embodiment of the invention to perform selective removal of rare earth based high-k materials selectively over silicon comprising substrates.

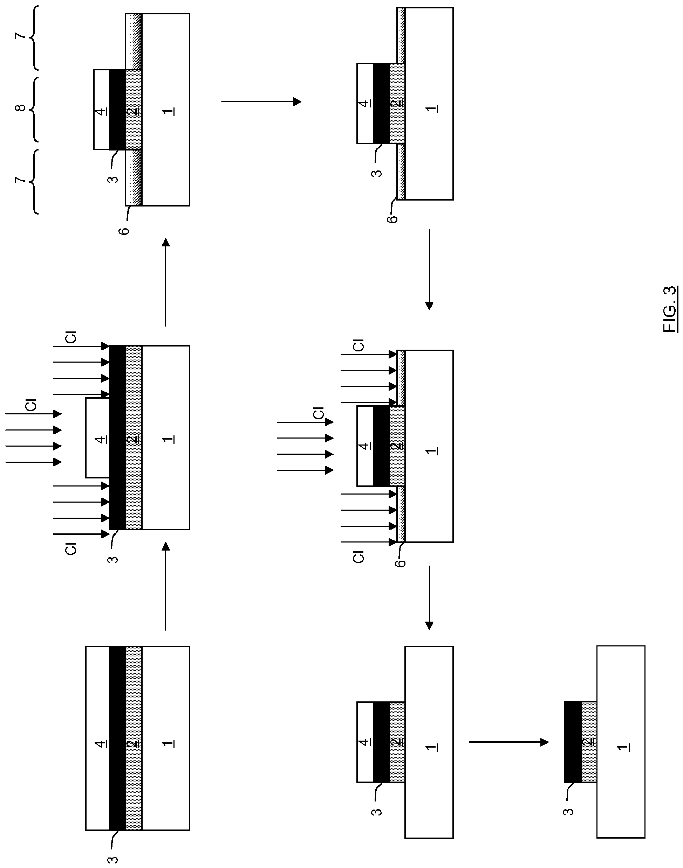

Figure 3 illustrates the different processing steps according to a preferred embodiment of the invention to perform selective removal of rare earth based high-k materials selectively over silicon comprising substrates whereby the chlorination is performed partly during the patterning of the gate electrode layer and completed during an additional chlorination step.

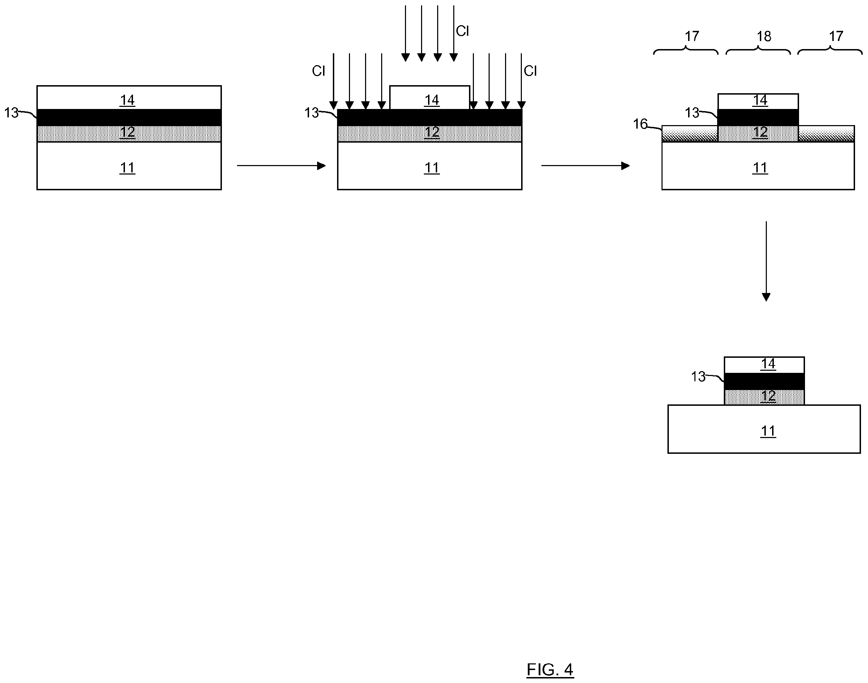

Figure 4 illustrates the different processing steps according to a preferred embodiment of the invention to perform selective removal of rare earth based high-k materials selectively over silicon comprising substrates whereby the chlorination is performed completely during the patterning of the gate electrode layer.

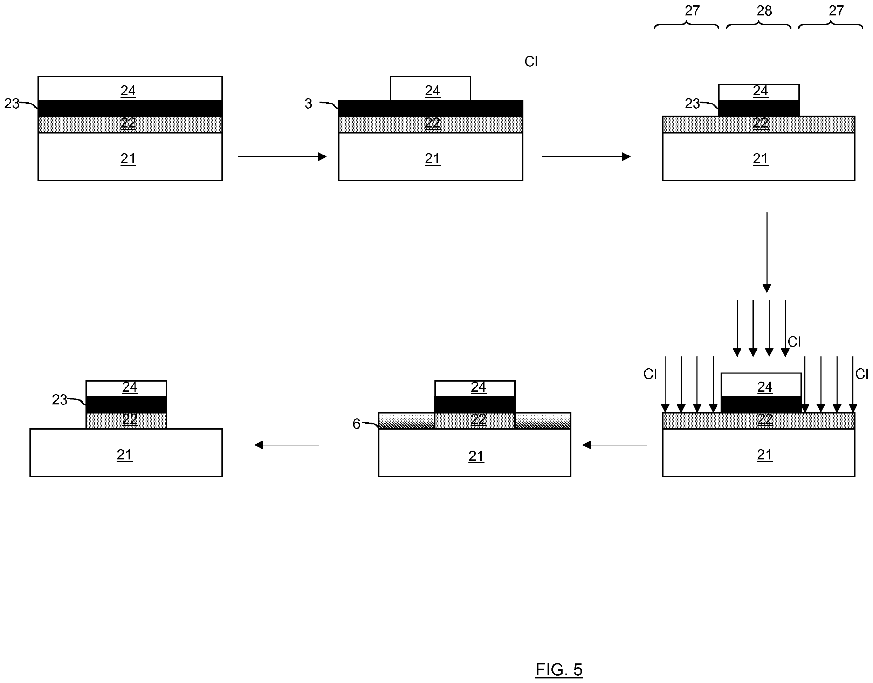

Figure 5 illustrates the different processing steps according to a preferred embodiment of the invention to perform selective removal of rare earth based high-k materials selectively over silicon comprising substrates whereby the chlorination is performed after the patterning of the gate electrode layer.

### DESCRIPTION OF THE INVENTION

The present invention will be described with respect to a preferred embodiment.

In a method of the invention, said chlorination and a bromination can be performed sequentially, both orders being envisaged, or can be performed simultaneously.

It is to be understood that the present invention also encompasses using a mixture of Cl-comprising plasma and Br-comprising plasma.

In a method of the invention, said Cl- and optionally Br-comprising plasma does not contain fluorine or fluorine containing compounds.

The present invention relates to a method for the patterning of a high-k comprising stack, more specifically it relates to the dry etching of high-k layers comprising (or consisting of) rare earth metal oxides.

More specifically a method is disclosed for patterning a high-k gate insulating structure in a semiconductor device. Said method comprises the steps of first providing a substrate and depositing a high-k layer onto said substrate. Subsequently a mask structure is developed to define a gate structure on said high-k layer and to expose parts of the high-k layer. The exposed parts of the high-k layer are then subjected to a Cl-based (or Cl-comprising) plasma to chlorinate at least part of the exposed high-k layer. Finally said chlorinated part of the high-k layer is removed using a wet etch.

More specifically, a method of the invention comprises the steps of providing a substrate, depositing a high-k layer onto the substrate, developing a mask structure to define a gate structure on the high-k layer and expose parts of the high-k layer, subjecting the exposed parts of the high-k layer to a Cl-based (or Cl-comprising) plasma to chlorinate at least part of the exposed high-k layer, and removing the chlorinated part of the high-k layer using a wet etch.

Preferably, the method of the invention further comprises before the step of developing a mask structure the steps of depositing a gate electrode layer onto said high-k layer, depositing photosensitive imaging layers and transferring a photolithographic pattern in said imaging layers to define the gate structure and transferring said gate structure pattern into said gate electrode layer.

Preferably the step of subjecting the exposed parts of the high-k layer is performed by an anisotropic dry-etch plasma.

Preferably the step of subjecting the exposed parts of the high-k layer is performed by an anisotropic dry-etch plasma during the step of patterning said gate electrode layer using a Cl based (or Cl-comprising) plasma whereby during the etching the exposed portions of said high-k layer gets chlorinated.

The high-k material is a high-k material comprising (or consisting of) rare earth elements.

More preferred said high-k material is a rare earth oxide selected from at least one of Dy₂O₃, La₂O₃, Pr₂O₃, Nd₂O₃, Gd₂O₃, Tb₂O₃, Ho₂O₃, Er₂O₃, Tm₂O₃, Yb₂O₃, Lu₂O₃.

Most preferred the high-k material is a rare earth scandate material selected from at least one of DyScO₃, LaScO₃, PrScO₃, NdScO₃, GdScO₃, TbScO₃, HoScO₃, ErScO₃, TmScO₃, YbScO₃ and LuScO₃.

A preferred example of the high-k material is DyScO₃.

Preferably the Cl-based (or Cl-comprising) plasma is a Cl₂ and/or BCl₃ comprising plasma.

Preferable the substrate is a silicon wafer.

In an alternative embodiment and also preferred an interlayer is deposited onto said substrate before depositing the high-k layer.

Preferably the gate electrode layer is a TaN, TiN, TaN/TiN layer.

The wet etch used in the invention is a water rinse.

Preferably the substrate bias during the step of subjecting the exposed parts of the high-k layer to a Cl-based (or Cl-comprising) plasma is -30V.

Preferably the plasma power during the step of subjecting the exposed parts of the high-k layer to a Cl-based (or Cl-comprising) plasma is in the range of 100W up to 1200W.

More preferred the plasma power during the step of subjecting the exposed parts of the high-k layer to a Cl-based (or Cl-comprising) plasma is around 450W.

Preferably the pressure in the plasma during the step of subjecting the exposed parts of the high-k layer to a Cl-based (or Cl-comprising) plasma is minimum 1.333Pa (lOmT) and maximum 10.665Pa (80mT).

More preferred the pressure in the plasma during the step of subjecting the exposed parts of the high-k layer to a Cl-based (or Cl-comprising) plasma is 1.333Pa (lOmT).

In relation to the drawings the present invention is described very briefly and general in the sequel. It is apparent, however, that a person skilled in the art knows how to perform the etch process in detail and compose an etch recipe.

In the context of the present invention, the term substrate bias refers to the voltage applied to the substrate in a Reactive Ion Etching (RIE) chamber. This value is expressed in Volt (as a negative number). The absence of substrate bias (Bias = 0) gives substantially no ion bombardment meaning almost no etching behavior. To achieve a vertical treatment (or exposure) of the substrate by the plasma, a substrate bias is preferred to avoid lateral etch of the structures due to exposure to plasma components.

In the context of the present invention, the term "anisotropic etch" refers to the etching process in which etch rate in the direction perpendicular to the surface (or substrate) is much higher than in direction parallel to the surface (or substrate). This in contrast to "isotropic etch" in which the etching occurs the same in any direction or being non-directional.

In the context of the present invention, the term "high-k material" refers to a dielectric material with a dielectric constant greater than the dielectric constant of silicon dioxide, k>4. As minimum feature sizes have shrunk it has been necessary to shrink the thickness of the gate oxides in proportion. Said high-k materials in the current invention are Rare-earth based high-k materials such as Dy and Sc comprising high-k materials.

In the context of the present invention, the term Rare-earth based high-k materials refers to high-k materials comprising rare earth elements such as rare earth scandates and rare earth oxides. Rare earth scandates refers to following structure ReScO₃ wherein Re= La, Pr, Nd, Sm, Gd, Tb, Dy, Ho, Er, Tm, Yb, or Lu, i.e., the entire series for which the individual oxides are chemically stable in contact with Si. Preferred examples of Rare-earth scandates in this invention are DyScO₃, LaScO₃, PrScO₃, NdScO₃, GdScO₃, TbScO₃, HoScO₃, ErScO₃, TmScO₃, YbScO₃ and LuScO₃. Rare earth oxides correspond to the following structure Re₂O₃ wherein Re= La, Pr, Nd, Sm, Gd, Tb, Dy, Ho, Er, Tm, Yb, or Lu. Examples of rare earth oxides are La₂O₃, Pr₂O₃, Nd₂O₃, Sm₂O₃, Gd₂O₃, Dy₂O₃, Y₂O₃, Er₂O₃, and Yb₂O₃.

In the context of the present invention "integrated circuit" includes devices formed on semiconducting substrates, such as group IV materials like silicon or germanium, or group III-V compounds like gallium arsenide, or structured substrate such as silicon-on-insulator, strained silicon and silicon-germanium, or mixtures of such materials. The term includes all types of devices formed, such as memory and logic, and all designs of such devices, such as MOS and bipolar. The term also comprehends applications such as flat panel displays, solar cells, and charge coupled devices.

The invention solves the problem of patterning rare earth based high-k materials such as Dy and Sc based high-k materials using reactive ion dry-etching techniques. More specifically the problem is the removal of said rare earth based high-k materials selectively over the Si substrate without making an undercut under the gate. The dry-etching of said rare earth based high-k materials (e.g. Dy and Sc) is hardly possible at close to room temperatures due to very low volatility of e.g. dysprosium and scandium halides (chlorides and/or bromides). The overview of the melting points (boiling points are not available) for dysprosium and scandium halides is presented in Table I. It is clear that making a volatile product at 60°C (wafer temperature during plasma etch in reactor) is impossible.

It is therefore an object of the present invention to provide a method for patterning rare earth based high-k materials such as Dy and Sc comprising high-k materials. More specifically a method is disclosed to allow selective removal of rare earth based high-k materials such as Dy and Sc comprising high-k materials selectively over Si comprising layers such as polycrystalline Si (poly-Si) and Silicon-dioxide (SiO₂) comprising layers using semiconductor compatible process technology steps.

The invention provides a method for forming a gate structure in an integrated circuit on a substrate and more specifically a high-k gate insulation structure. A high-k layer is first deposited onto the substrate, and patterned with a mask to define the high-k gate insulation layer and exposed portions of the high-k layer. The exposed portions of the high-k layer are subjected to in-situ plasma species that causes chlorination of the exposed portions of the high k layer. Said in-situ plasma is a Cl-based (or Cl-comprising) plasma. The chlorinated portions of the high-k layer can be selectively wet etched to leave the high-k gate insulation gate structure.

The method of the invention is used to pattern a high-k comprising stack of gate stack layers. Said stack of layers is situated or deposited onto a substrate, most preferred said substrate is a silicon wafer. The aim of the patterning is to pattern or to form a gate structure in said gate stack layers. Said gate structure comprises at least one gate electrode (layer) and at least one gate oxide (layer) situated below said gate electrode layer.

Optionally an interlayer can be deposited onto the substrate before depositing said gate stack layers, said interlayer can be a thermally grown SiO₂ layer. Said thermally grown SiO₂ can be formed by subjecting the (silicon) substrate to a HF dip (2%HF for a few minutes).

Most preferred the gate stack layer used to form the gate electrode is a TiN, TiN/TaN or TaN layer. Other suitable gate electrode layers are also possible.

The gate stack layer used to form the gate oxide (also referred to as gate insulator) is a high-k layer. More specifically, the high-k layer used in the invention is a rare earth comprising (or based, or consisting of) high-k material such as a Dy and Sc comprising high-k materials.

The present invention solves the problem of removal of rare earth based high-k materials, more specifically Dy and/or Sc comprising high-k materials such as DyScO₃ or Dy₂O₃ high-k dielectric materials selectively over a silicon comprising substrate without making an undercut under the gate structure. Dry removal is impossible since neither Dy nor Sc form volatile compounds. Wet removal is possible, but due to isotropic nature of wet etch it etches the DyScO dielectric also laterally, creating an undercut at the gate edge beneath the gate.

The present invention solves the problem of insufficient etch rate for rare earth based high-k materials such as Dy and Sc comprising high-k materials (e.g. DyScO₃) by first performing a chlorination step using a dry-etch plasma such that rare earth comprising halides (chlorides) are formed (e.g. DyCl₃ and ScCl₃) which are water soluble. In a second step said rare earth comprising halides (chlorides) are selectively removed from the substrate using a wet removal step. Said wet removal step is performed using water, preferably a deionized water rinse.

The method of the invention solves the problem by chlorinating the rare earth based high-k materials by means of a chlorine containing plasma (e.g. Cl₂ and/or BCl₃). In case said rare earth based high-k material is a Dy and/or Sc comprising high-k material such as DyScO₃ or Dy₂O₃ both Dy and Sc chlorides (e.g. DyCl₃ and ScCl₃) are water soluble such that they can be removed by water rinse. The method of the invention further provides the advantage of selective removal of rare earth based high-k materials over a silicon comprising substrate because Si is not etched by means of water. The method of the invention furthermore provides the advantage of avoiding or eliminating undercut in the patterned gate structure since the non-chlorinated rare earth based high-k material e.g. non-chlorinated DyScO₃ is not water soluble and hence only the chlorinated part of the rare earth based high-k dielectric layer is removed by water. Since the plasma chlorination of the invention is anisotropic, the dielectric beneath the gate is not chlorinated and, therefore, not removed by water.

In a preferred embodiment said chlorination step is at least partly performed during the step of patterning the gate electrode layer. In case the gate electrode layer is a metal comprising layer such as a TaN, TiN or a combination of a TaN/TiN layer, the patterning is performed using a chlorine comprising gas. Said chlorine comprising gas is preferably Cl₂ and/or BCl₃ since titanium and tantalum chlorides are volatile and reasonable selectivity to silicon comprising material on the wafer substrate (Si, SiO₂) can be obtained. During the patterning of the gate electrode layer, the rare earth based high-k material gets exposed to the chlorine comprising gas such that it becomes at least partly chlorinated.

Said chlorinated part of the rare earth based can be removed after etch by performing a wet removal step. In case the rare earth based high-k material is a Dy and/or Sc based materials (e.g. DyScO₃ or Dy₂O₃) said wet removal is a water based removal, most preferred said removal is a water rinse.

Figure 2 shows a flowchart illustrating the process flow according to a preferred embodiment of the invention wherein the rare earth based high-k material is at least partly chlorinated during the patterning of the gate electrode layer and Figure 3 illustrates the different processing steps according to said preferred embodiment. The method start with providing a substrate 1, most preferred said substrate is Si wafer comprising active areas (e.g. source and drain). Optionally an interlayer can be deposited onto said substrate, said interlayer can be e.g. a thermally grown SiO₂ layer obtained after a thermal anneal or an HF dip (e.g. a dip in a 2% HF solution). Alternatively said interlayer can be a thin deposited layer such as e.g. a silicon nitride or silicon oxynitride layer with a thickness up to maximum 2nm. Onto said substrate 1 a rare earth based high-k layer 2 is deposited, said rare earth based high-k layer 2 is preferably formed with a thickness of about 1nm up to maximum 20nm, and is preferably formed of an oxide of a rare earth metal, including at least one of the elements La, Pr, Nd, Sm, Gd, Tb, Dy, Ho, Er, Tm, Yb, and Lu and most preferred said rare earth based high-k material is a Dy and/or Sc comprising high-k material such as DyScO₃ and/or Dy₂O₃. The rare earth based high-k layer 2 is preferably initially formed as an amorphous layer, although depending upon the process used, it may also be initially formed as a crystalline layer, a further heat treatment can therefore be wanted upon becoming crystalline. It is further appreciated that the designation of the term "substrate" as used in the whole application refers to either the substrate without an additional interlayer or both to the substrate and all other layers -including the interlayer- which are formed on top of the substrate before the deposition of a high-k dielectric layer. Subsequently, a gate electrode layer **3** is deposited onto said rare earth based high-k layer **2.** Said gate electrode layer **3** is preferably a metal comprising layer such as a TaN, TiN or a combination of a TaN/TiN layer. A mask layer is then deposited onto said gate electrode layer **3,** most preferred said mask layer is a photosensitive imaging layer(s) **4,** optionally there can be a hardmask layer such as silicon nitride deposited before the deposition of said photosensitive imaging layer(s) **4.** A gate pattern is then transferred into said photosensitive imaging layer(s) **4** by means of photolithographic patterning. An anisotropical dry-etching process is then applied to etch a gate structure **8** in said gate electrode layer **3,** the plasma used to pattern the gate electrode layer **3** is a Cl-based (or Cl-comprising) plasma such as Cl₂ and/or BCl₃ comprising plasmas. The plasma can further comprise inert compounds and/or nitrogen. During the dry-etching of gate electrode layer **3** the rare earth based high-k layer **2** is not etched because said high-k layer **2** tends to be extremely resistive to etching, as described above. Therefore, the high k layer **2** tends to provide an excellent etch stop to the etching process used to define the gate electrode layer **3.** The patterned gate electrode layer **3** therefore also defines a high-k gate insulation layer region **7,** which defines exposed portions **7** of the high-k layer **2.** The exposed portions **7** of the high k layer **2** are subjected to an in-situ plasma of Cl species that causes chlorination to the exposed portions **7** of the high k layer **6,** as depicted in Figure 3. However, the overlying gate structure **8** prohibits the in-situ plasma from chlorination of the high-k layer **2** in that region **8.**

Further illustrated in Figure 3, the partly chlorinated high-k layer **6** is removed by means of a wet etch. Said high-k layer is preferably a Dy and/or Sc comprising high-k material such as DyScO₃ and/or Dy₂O₃ and said wet etch is preferably a water rinse. To remove the high-k layer completely (selectively over the substrate) another chlorination step is needed, most preferred said chlorination step is an exposure of said high-k layer **6** to a Cl-comprising plasma. It is appreciated here that the energy of the plasma is not too high to avoid structural damage of the underlying substrate **1** and structures of the integrated circuit. It is intended to avoid damage to the underlying substrate or layer, preferably the substrate bias is around -30V (substrate bias should however be kept different from zero to avoid lateral exposure). The time of exposure of the high-k layer to the Cl-(comprising) plasma should be sufficient to obtain complete chlorination. In a next step the remaining chlorinated high-k layer **6** will be removed by means of a wet etch as described above. In the case where the etchants did not remove the photosensitive imaging layer(s) **4** additional steps can be used for removing said layers as well as cleaning the surfaces of the subsequent structures.

Illustrated in Figure 4, the exposed portions **17** of the high k layer **12** are subjected to an in-situ plasma of Cl species that causes chlorination to the exposed portions **17** of the high k layer **16.** The chlorination of the high-k layer **12** is performed during the etching (patterning) of the gate electrode layer **14** by means of an in-situ plasma comprising chlorine (Cl) species (ions, radicals and atoms). Time and exposure of said chlorination is such that complete chlorination of the exposed portions of the high-k layer is obtained. It is therefore preferred to extend the exposure to the Cl comprising plasma or in other words have further (extended) exposure to the Cl comprising plasma after the gate electrode patterning has been completed. Most preferred the substrate bias during said extended Cl exposure step is different from zero to avoid lateral exposure, a suitable substrate bias can be -30V. In the case where the etchants did not remove the photosensitive imaging layer(s) **14** additional steps can be used for removing said layers as well as cleaning the surfaces of the subsequent structures. The time of the chlorination should be such that the underlaying substrate or layer is not damaged or attacked.

In yet another and also preferred embodiment (as illustrated in Figure 5), the plasma used to pattern the gate electrode layer **24** is not a chlorine comprising plasma and no chlorination occurs during the patterning of the gate electrode layer **24.** The chlorination (or exposure to a Cl (comprising) plasma) of exposed portions **27** of the high-k layer **23** is therefore performed after the patterning of the gate electrode layer **24.** Said exposure can be done by means of an in-situ plasma having Cl species (ions, radicals and atoms).

To obtain a complete removal of the rare earth based high-k layer **23** such that a fully patterned gate oxide layer (rare earth based high-k layer) is obtained, the exposure time to the chlorine comprising plasma should be sufficient. It is preferred to have immediately after the patterning of the gate electrode layer **24,** a further exposure step during which the high-k layer **23** is further chlorinated. Said further exposure step is preferably performed before removing the substrate out of the plasma etch chamber. In the case where the etchants did not remove the photosensitive imaging layer(s) **4** additional steps can be used for removing said layers as well as cleaning the surfaces of the subsequent structures.

In case a chlorine containing gas is used which further comprises nitrogen as inert compound, a watersoluble Boron-Nitrogen (BxNy) comprising film can be deposited during patterning depending on the plasma conditions. Said Boron-Nitrogen film is preferably deposited onto the vertical sidewalls of a patterned structure (the gate structure) during patterning. Said Boron-Nitrogen film is preferably advantageous when one of the gate stack layers is too sensitive to a chlorine comprising plasma such that vertical sidewalls of a patterned gate structure can be protected and sidewall damage during further patterning is avoided. Said Boron-Nitrogen film can also be partly deposited onto the horizontal surfaces depending on the bias setting during patterning (or in other words voltage applied to the substrate during the patterning). Said Boron-Nitrogen film can be removed simultaneously with the removal of the chlorinated part of the rare earth based high-k layer by means of a wet removal step, most preferred said removal step is a water rinse.

Preferably, the chlorine comprising plasma used to perform the chlorination of the rare earth based high-k material of the present invention (during patterning or after patterning of the gate electrode) has a substrate bias which is different from zero. Most preferred said substrate bias is around -30 Volt.

Preferably, the chlorine comprising plasma used to perform the chlorination of the rare earth based high-k material such as Dy and/or Sc comprising high-k material (e.g. DyScO₃ and/or Dy₂O₃) of the present invention (during patterning or after patterning of the gate electrode) has a plasma power in the range of 100W up to 1200W. More preferred said plasma power is around 450W.

Preferably, the pressure in the plasma chamber used to perform the chlorination of the rare earth based high-k layer of the present invention (during patterning or after patterning of the gate electrode) is in the range of minimum 0.666 Pa (5mT) and maximum 10.665 Pa (80mT). More preferred said pressure is 1.333 Pa (10mT).

Preferably, the chlorine comprising plasma used to perform the chlorination of the rare earth based high-k layer of the present invention (during patterning or after patterning of the gate electrode) has a plasma temperature below 100°C and most preferred said plasma temperature during dry-etch patterning is around 60°C.

The preferred time of exposure of the rare earth based high-k layer to the chlorine comprising plasma is dependent on the thickness of the high-k layer, the plasma settings such as substrate bias, etc. A higher substrate bias will give more ion bombardment and can therefore reduce thickness of the rare earth based high-k layer (e.g. DyScO₃) during exposure to the Chlorine plasma.

If needed the sequence of first a step of chlorination in a chlorine comprising plasma followed by the step of removing the chlorinated part of the rare earth based high-k layer can be repeated until complete removal (selective) of the comprising high-k layer and/or complete patterning of the gate structure is obtained.

If needed the step of chlorination of the rare earth based high-k layer during the patterning of the gate electrode (simultaneously chlorinated) can be combined with the step in which chlorination step is performed after patterning.

It is further an aim of the invention to disclose the use of a Cl-based (or Cl-comprising) plasma for the chlorination of the rare earth based high-k layer such that a selective removal of the rare earth based high-k layer towards silicon and silicon dioxide is possible. Said removal is performed using a wet removal step in water, most preferred said wet removal step is a water rinse.

Since Dy and Sc (and their oxides) are difficult to etch, the etching could be easily stopped on them. For patterning of the metal gates (TiN and TaN) on top of Dy and/or Sc comprising high-k material (e.g. DyScO₃ and/or Dy₂O₃), chlorine-containing gases (Cl₂ and/or BCl₃) can be used since titanium ant tantalum chlorides are volatile and reasonable selectivity to other material present on the wafer (Si, SiO₂) can be obtained.

### EXAMPLES

### Example 1: Deposition of DySCO₃ layer

DyScO₃ layers are deposited by Atomic Vapor Deposition (AVD®). AVD® introduces the precursors in a pulsed mode through separate, independent injectors. All layers were deposited on a thin SiO₂ layer made in a DI H₂O/O₃ solution. This treatment results in a SiO₂ layer, approximately 0.8nm thick, and is often referred to as an "IMEC-clean" starting surface. The precursors used to deposit DyScO layers by AVD® in the experiment are Dy(mmp)₃ ([Tris(1-methoxy-2-methyl-2-propoxy)Dysprosium; Dy(OC(CH₃)₂CH₂OCH₃)₃]) and Sc(mmp)₃ ([Tris(1-methoxy-2-methyl-2-propoxy) Scandium; Sc(OC(CH₃)₂CH₂OCH₃)]). In Figure 2 a growth curve is shown for DyScO with a Dy/Sc ratio of 80/20. A linear relation is found between the thickness and the total number of injected pulses. Variation of the ratio of injected Dy to Sc-pulses allows changing the composition of the deposited layer and it has been shown that these precursors allow the deposition of layers that span the range from pure Dy₂O₃ to pure Sc₂O₃. The efficiency of the Sc-precursor was found to be a factor of 6 higher as compared to the Dy-precursor. As a result, a 50/50 composition is obtained for a precursor pulse ratio [Dy/(Dy+Sc)] equal to 0.86. The layers were found to be very smooth by Atomic force Microscopy measurements with rms/thickness values between 3 and 5% for ∼5nm thick layers. The precursors are dissolved in toluene (using tetraglyme as stabilizer) in a concentration of 0.1M.

The thickness of the layers was measured by Spectroscopic Ellipsometry (SE) using a KLA/TENCOR ASET F5. A single-layer model was used to determine the refractive index and thickness of the deposited layer (i.e. high-k layer and interfacial layer (IL) in between the high-k layer and the Si-substrate are measured as one layer). For a selected sample set, the SE thickness was verified by Transmission Electron Microscopy (TEM), demonstrating a good correlation between the different techniques.

The composition of the different layers was determined by X-ray Photoelectron Spectroscopy (XPS) or Rutherford Backscattering Spectroscopy (RBS). The amount of contamination in the layers was assessed by Time of Flight Secondary Ion Mass Spectroscopy (ToF-SIMS). The surface roughness was measured by Atomic Force Microscopy (AFM).

### Example 2: Use of a BCl₃ or Cl₂ plasma to chlorinate a DySCO₃ layer and removal of the chlorinated DySCO₃ by water.

Wafers having DyScO₃ layers which are deposited by Atomic Vapor Deposition (AVD®) were etched in LAM Versys2300 TCP etch reactor that allows separate control of plasma power and substrate bias. The etch was done using either of two gases, Cl₂ or BCl₃ at 450W plasma power, -30V substrate bias, 10 mT pressure for 30 s. The thickness of the layer before and after etch was measured by spectroscopic ellipsometry. Then the etched layers were subjected to 10 min DI water rinse and the thickness was measured again.

Etch rate tests performed on blanket DyScO₃ (layer of 30 nm) wafers confirm the predictions. In the case of Cl₂, 1.5 nm of DyScO₃ was removed probably by physical sputtering. Water rinse removed additional 1.2 nm (probably the chlorinated surface layer). BCl₃ was found to deposit a layer of 4.3 nm BxNy on top of DyScO₃ (the layer contains B and Cl and is water soluble). The water rinse removed the deposited layer plus 1.5 nm of DyScO₃ (probably the chlorinated surface layer).

We can conclude that at the mentioned conditions the etch rate is about 3 nm/min in pure Cl₂ and zero in pure BCl₃. Both gases chlorinate the top 1-1.5 nm layer of DyScO₃ in 30 s that can be removed by water rinse.

It can be concluded that chlorination of the DyScO₃ materials by means of a Cl₂ plasma and/or BCl₃ plasma makes it possible to transform the DyScO₃ materials into a chlorinated DyScO₃ material which is water soluble such that it can be selectively removed towards silicon, silicon dioxide and other materials used as gate stack materials in a semiconductor device.

Figure 1 illustrates DyScO₃ thickness after the removal experiments using the method of the invention. The initial thickness is 10 nm, after exposure to Cl₂ plasma for 30 s about 1.5 nm is removed, probably due to physical sputtering. The BCl₃ plasma deposits as film on top (probably BxCly film), but does not result in the thickness decrease. Water rinse removes around 1.5 nm in the case of DyScO exposure to Cl₂ (probably, the chlorinated layer) and around 5.5 nm in the case of BCl₃ exposure (BxCly film plus chlorinated Dy and/or Sc comprising high-k layer (e.g. DyScO₃ and/or Dy₂O₃)). The thickness of the Dy and/or Sc comprising high-k layer (e.g. DyScO₃ and/or Dy₂O₃) in real devices usually in the range of 2-4 nm.

**Table I: Melting points of Dysprosium and Scandium halides.**

| Compound (M=Dy or Sc) | Melting point, °C | |
|---|---|---|
| | Dy | Sc |
| MF₃ | 1154 | 1515 |
| MCl₃ | 680 | 967 |
| MBr₃ | 879 | 969 |

## Claims

1. A method for patterning a high-k gate insulating structure (8) in a semiconductor device for the manufacture of a semiconductor device comprising selectively removing a high-k layer comprising rare earths (2) over a substrate (1), said selective removal comprising the steps of:
- providing a substrate,
- depositing a high-k rare earth(s) comprising layer onto said substrate,
- forming a gate electrode structure on said high-k layer and exposing parts of the high-k layer,
- subjecting the exposed parts (7) of the high-k rare earth(s) comprising layer (2) to a Cl-comprising plasma for chlorinating at least part of said exposed high-k rare earth(s) comprising layer,
- contacting or rinsing the resulting chlorinated layer (6) with water, for removing said chlorinated layer (6).

2. A method according to claim 1, wherein said rare earth comprising layer (2) consists of a rare earth oxide selected from the group consisting of La₂O₃, Pr₂O₃, Nd₂O₃, Gd₂O₃, Tb₂O₃, Dy₂O₃, Ho₂O₃, Er₂O₃, Tm₂O₃, Yb₂O₃, and Lu₂O₃.

3. A method according to claim 2, wherein said rare earth oxide is dysprosium oxide.

4. A method according to claim 1, wherein said rare earth comprising layer (2) consists of a rare earth scandate.

5. A method according to claim 4, wherein said rare earth scandate is selected from the group consisting of LaScO₃, PrScO₃, NdScO₃, GdScO₃, TbScO₃, DyScO₃, HoScO₃, ErScO₃, TmScO₃, YbScO₃, and LuScO₃.

6. A method according to claim 5, wherein said rare earth scandate is dysprosium scandate.

7. A method according to any of claims 1 to 6, wherein said rare earth(s) comprising layer (2) is deposited by Atomic Vapor Deposition.

8. A method according to any of claims 1 to 7, wherein said substrate (1) is not soluble in aqueous solutions or in water.

9. A method according to any of claims 1 to 8, wherein said substrate (1) is a silicon wafer.

10. A method according to any of claims 1 to 9, whereby an interlayer is deposited onto said substrate before depositing said high-k rare earth(s) comprising layer.

11. A method according to claim 10, wherein said interlayer is a thermally grown SiO₂ layer, or a thin deposited silicon nitride or silicon oxynitride layer with a thickness up to 2 nm.

12. A method according to any of claims 1 to 11, wherein said plasma is anisotropically applied.

13. A method according to any of claims 1 to 12, wherein said Cl-comprising plasma is a Cl₂ comprising plasma and/or BCl₃ comprising plasma.

14. A method according to any of claims 12 or 13, wherein, during the step of subjecting said exposed parts (7), to said plasma, the substrate bias applied is -30V.

15. A method according to any of claims 1 to 14, wherein, during the step of subjecting said exposed parts (7), to a Cl-comprising plasma, the plasma power is in the range of 100W up to 1200W.

16. A method according to claim 15, wherein said plasma power is around 450W.

17. A method according to any of claims 1 to 16, wherein, during the step of subjecting said exposed parts (7), to a Cl-comprising plasma, the pressure in the plasma is minimum 1.333Pa (lOmT) and maximum 10.665Pa (80mT).

18. A method according to claim 17, wherein said pressure is 1.333Pa (10mT).

19. A method according to any of claims 1 to 18, said step of forming a gate electrode structure further comprising, after having deposited said high-k rare earth(s) comprising layer(s), the steps of
- Depositing a gate electrode layer (3) onto said high-k rare earth(s) comprising layer(s) (2),
- Depositing photosensitive imaging layers (4) and transferring a photolithographic pattern in said imaging layers to define the gate structure (8),
- Transferring said gate structure pattern into said gate electrode layer (3),
- Developing a mask structure to define a gate structure on said high-k layer(s) and expose parts of said high-k layer(s).

20. A method according to any of claims 1 to 19, wherein the step of subjecting said exposed parts (7) of said high-k layer(s) (2) is performed by an anisotropic dry-etch plasma.

21. A method according to claim 19 or 20, wherein the step of subjecting said exposed parts (7) of said high-k rare earth(s) comprising layer (s) (2) and the step of patterning said gate electrode layer (3) are simultaneous, using a Cl-comprising plasma whereby, during the etching, said exposed parts (7) of said high-k rare earth(s) comprising layer(s) (2) get chlorinated.

22. A method according to any of claims 19 to 21, wherein said gate electrode layer (3) is a TaN, TiN, or TaN/TiN layer.

## Patentansprüche

1. Verfahren zum Strukturieren einer High-k-Gate-Isolationsstruktur (8) in einer Halbleitervorrichtung für die Herstellung einer Halbleitervorrichtung, das wahlweise Entfernen einer High-k-Schicht (2), die Seltenerden umfasst, über einem Substrat (1) umfassend, wobei das wahlweise Entfernen folgende Schritte umfasst:
- Bereitstellen eines Substrats,
- Abscheiden einer Seltenerde(n) umfassenden High-k-Schicht auf dem Substrat,
- Bilden einer Gate-Elektrodenstruktur auf der High-k-Schicht und Freilegen von Teilen der High-k-Schicht,
- Aussetzen der freiliegenden Teile (7) der Seltenerde(n) umfassenden High-k-Schicht (2) einem Cl-umfassenden Plasma, um zumindest einen Teil der freiliegenden Seltenerde(n) umfassenden High-k-Schicht zu chlorieren,
- In-Kontakt-Bringen oder Spülen der entstandenen chlorierten Schicht (6) mit Wasser, um die chlorierte Schicht (6) zu entfernen.

2. Verfahren nach Anspruch 1, wobei die Seltenerde umfassende Schicht (2) aus einem Seltenerdoxid besteht, das aus der Gruppe ausgewählt ist, die aus La₂O₃, Pr₂O₃, Nd₂O₃, Gd₂O₃, Tb₂O₃, Dy₂O₃, Ho₂O₃, Er₂O₃, Tm₂O₃, Yb₂O₃, und Lu₂O₃ besteht.

3. Verfahren nach Anspruch 2, wobei das Seltenerdoxid Dysprosiumoxid ist.

4. Verfahren nach Anspruch 1, wobei die Seltenerde umfassende Schicht (2) aus einem Seltenerdscandat besteht.

5. Verfahren nach Anspruch 4, wobei das Seltenerdscandat aus der Gruppe ausgewählt ist, die aus LaScO₃, PrScO₃, NdScO₃, GdScO₃, TbScO₃, DyScO₃, HoScCO₃, ErScO₃, TmScO₃, YbScO₃, und LuScO₃ besteht.

6. Verfahren nach Anspruch 5, wobei das Seltenerdscandat Dyprosiumscandat ist.

7. Verfahren nach einem der Ansprüche 1 bis 6, wobei die Seltenerde(n) umfassende Schicht (2) durch Atomdampfabscheidung (AVD) abgeschieden wird.

8. Verfahren nach einem der Ansprüche 1 bis 7, wobei das Substrat (1) in wässriger Lösung oder Wasser nicht löslich ist.

9. Verfahren nach einem der Ansprüche 1 bis 8, wobei das Substrat (1) ein Silicium-Wafer ist.

10. Verfahren nach einem der Ansprüche 1 bis 9, wobei vor dem Abscheiden der Seltenerde(n) umfassenden High-k-Schicht eine Zwischenschicht auf das Substrat abgeschieden wird.

11. Verfahren nach Anspruch 10, wobei die Zwischenschicht eine thermisch aufgewachsene SiO₂-Schicht oder eine dünne abgeschiedene Siliciumnitrid- oder Siliciumoxynitridschicht mit einer Dicke von bis zu 2 nm ist.

12. Verfahren nach einem der Ansprüche 1 bis 11, wobei das Plasma anisotrop aufgebracht wird.

13. Verfahren nach einem der Ansprüche 1 bis 12, wobei das Cl-haltige Plasma ein Cl₂ umfassendes Plasma und/oder BCl₃ umfassendes Plasma ist.

14. Verfahren nach einem der Ansprüche 12 oder 13, wobei die angelegte Substratvorspannung während des Schritts, in dem die freiliegenden Teile (7) dem Plasma ausgesetzt werden, -30 V beträgt.

15. Verfahren nach einem der Ansprüche 1 bis 14, wobei die Plasmaleistung während des Schritts, in dem die freiliegenden Teile (7) einem Cl umfassenden Plasma ausgesetzt werden, im Bereich von 100 W bis 1200 W liegt.

16. Verfahren nach Anspruch 15, wobei die Plasmaleistung rund 450 W beträgt.

17. Verfahren nach einem der Ansprüche 1 bis 16, wobei der Druck im Plasma während des Schritts, in dem die freiliegenden Teile (7) einem Cl umfassenden Plasma ausgesetzt werden, minimal 1,333 Pa (10 mT) und maximal 10,665 Pa (80 mT) beträgt.

18. Verfahren nach Anspruch 17, wobei der Druck 1,333 Pa (10 mT) beträgt.

19. Verfahren nach einem der Ansprüche 1 bis 18, wobei der Schritt des Bildens einer Gate-Elektrodenstruktur, nachdem die Seltenerde(n) umfassende(n) High-k-Schicht(en) abgeschieden wurde(n), ferner folgende Schritte umfasst
- Abscheiden einer Gate-Elektrodenschicht (3) auf der/den Seltenerde(n) umfassenden High-k-Schicht(en) (2),
- Abscheiden fotoempfindlicher Abbildungsschichten (4) und Übertragen einer fotolithografischen Struktur in die Abbildungsschichten, um die Gate-Struktur (8) zu definieren,
- Übertragen der Gate-Struktur in die Gate-Elektrodenschicht (3),
- Entwickeln einer Maskenstruktur, um eine Gate-Struktur auf der/den High-k-Schicht(en) zu definieren und Teile der High-k-Schicht(en) freizulegen.

20. Verfahren nach einem der Ansprüche 1 bis 19, wobei der Schritt, in dem die freiliegenden Teile (7) der High-k-Schicht(en) (2) ausgesetzt werden, durch ein anisotropes Trockenätz-Plasma ausgeführt wird.

21. Verfahren nach Anspruch 19 oder 20, wobei der Schritt, in dem die freiliegenden Teile (7) der Seltenerde(n) umfassenden High-k-Schicht(en) (2) ausgesetzt werden, und der Schritt des Strukturierens der Gate-Elektrodenschicht (3) gleichzeitig unter Verwendung eines Cl umfassenden Plasmas erfolgen, wobei die freiliegenden Teile (7) der Seltenerde(n) umfassenden High-k-Schicht(en) (2) während des Ätzens chloriert werden.

22. Verfahren nach einem der Ansprüche 19 bis 21, wobei die Gate-Elektrodenschicht (3) eine TaN-, TiN-, oder TaN/TiN-Schicht ist.

## Revendications

1. Procédé pour former un motif sur une structure isolante de grille ayant une constante diélectrique k élevée (8) dans un dispositif semi-conducteur pour la fabrication d'un dispositif semi-conducteur, comprenant l'élimination sélective d'une couche ayant une constante diélectrique k élevée comprenant des terres rares (2) sur un substrat (1), ladite élimination sélective comprenant les étapes consistant à:
- disposer d'un substrat,
- déposer une ou plusieurs terres rares ayant une constante diélectrique k élevée sur ledit substrat,
- former une structure d'électrode de grille sur ladite couche ayant une constante diélectrique k élevée et exposer des parties de la couche ayant une constante diélectrique k élevée,
- soumettre les parties exposées (7) de la couche comprenant la ou les terres rares (2) ayant une constante diélectrique k élevée à un plasma comprenant du Cl pour chlorer au moins une partie de la couche comprenant la ou les terres rares ayant une constante diélectrique k élevée,
- mettre en contact ou rincer la couche chlorée résultante (6) avec de l'eau, pour éliminer ladite couche chlorée (6).

2. Procédé selon la revendication 1, dans lequel ladite couche comprenant des terres rares (2) est constituée d'un oxyde de terres rares choisi dans l'ensemble constitué par La₂O₃, Pr₂O₃, Nd₂O₃, Gd₂O₃, Tb₂O₃, Dy₂O₃, Ho₂O₃, Er₂O₃, Tm₂O₃, Yb₂O₃, et Lu₂O₃.

3. Procédé selon la revendication 2, dans lequel ledit oxyde de terres rares est l'oxyde de dysprosium.

4. Procédé selon la revendication 1, dans lequel ladite couche comprenant des terres rares (2) est constituée d'un scandate de terres rares.

5. Procédé selon la revendication 4, dans lequel ledit scandate de terres rares est choisi dans l'ensemble constitué par LaScO₃, PrScO₃, NdScO₃, GdScO₃, TbScO₃, DyScO₃, HoScO₃, ErScO₃, TmScO₃, YbScO₃, et LuScO₃.

6. Procédé selon la revendication 5, dans lequel ledit scandate de terres rares est le scandate de dysprosium.

7. Procédé selon l'une quelconque des revendications 1 à 6, dans lequel ladite couche comprenant une ou des terres rares (2) est déposée par déposition atomique en phase vapeur.

8. Procédé selon l'une quelconque des revendications 1 à 7, dans lequel ledit substrat (1) n'est pas soluble dans les solutions aqueuses ou dans l'eau.

9. Procédé selon l'une quelconque des revendications 1 à 8, dans lequel ledit substrat (1) est une galette de silicium.

10. Procédé selon l'une quelconque des revendications 1 à 9, dans lequel une couche intermédiaire est déposée sur ledit substrat avant la déposition de ladite couche comprenant une ou des terres rares ayant une constante diélectrique k élevée.

11. Procédé selon la revendication 10, dans lequel ladite couche intermédiaire est une couche de SiO₂ ayant crû thermiquement, ou une couche mince d'oxynitrure de silicium ou de nitrure de silicium déposé ayant une épaisseur allant jusqu'à 2 nm.

12. Procédé selon l'une quelconque des revendications 1 à 11, dans lequel ledit plasma est appliqué par voie anisotropique.

13. Procédé selon l'une quelconque des revendications 1 à 12, dans lequel ledit plasma comprenant du Cl₂ est un plasma comprenant du Cl₂ et/ou un plasma comprenant du BCl₃.

14. Procédé selon l'une quelconque des revendications 12 et 13, dans lequel, durant l'étape consistant à soumettre lesdites parties exposées (7) audit plasma, la polarisation appliquée au substrat est de -30 V.

15. Procédé selon l'une quelconque des revendications 1 à 14, dans lequel, durant l'étape consistant à soumettre lesdites parties exposées (7) à un plasma comprenant du Cl, la puissance du plasma est située dans la plage allant de 100 W jusqu'à 1200 W.

16. Procédé selon la revendication 15, dans lequel ladite puissance du plasma est d'environ 450 W.

17. Procédé selon l'une quelconque des revendications 1 à 16, dans lequel, durant l'étape consistant à soumettre lesdites parties exposées (7) à un plasma comprenant du Cl, la pression dans le plasma est au minimum de 1,333 Pa (10 mT) et au maximum de 10,665 Pa (80 mT).

18. Procédé selon la revendication 17, dans lequel ladite pression est de 1,333 Pa (10 mT).

19. Procédé selon l'une quelconque des revendications 1 à 18, dans lequel ladite étape de formation d'une structure d'électrode de grille comprend en outre, après que la ou les couches comprenant une ou des terres rares ayant une constante diélectrique k élevée ont été déposées, les étapes consistant à
- déposer une couche d'électrode de grille (3) sur ladite ou lesdites couches comprenant une ou des terres rares ayant une constante diélectrique k élevée (2),
- déposer des couches de formation d'image photosensibles (4) et transférer un motif photolithographique dans lesdites couches de formation d'image pour définir la structure de grille (8),
- transférer ledit motif de structure de grille dans ladite couche d'électrode de grille (3),
- développer une structure de masque pour définir une structure de grille sur ladite ou lesdites couches ayant une constante diélectrique k élevée et exposer des parties de ladite ou desdites couches ayant une constante diélectrique k élevée.

20. Procédé selon l'une quelconque des revendications 1 à 19, dans lequel l'étape consistant à soumettre lesdites parties exposées (7) de ladite ou desdites couches ayant une constante diélectrique k élevée (2) est effectuée au moyen d'un plasma de gravure sèche anisotropique.

21. Procédé selon la revendication 19 ou 20, dans lequel l'étape consistant à soumettre lesdites parties exposées (7) de ladite ou desdites couches comprenant une ou des terres rares ayant une constante diélectrique k élevée (2) et l'étape consistant à doter d'un motif ladite couche d'électrode de grille (3) sont simultanées et utilisent un plasma comprenant du Cl grâce auquel, durant la gravure, lesdites parties exposées (7) de ladite ou desdites couches comprenant une ou des terres rares ayant une constante diélectrique k élevée (2) deviennent chlorées.

22. Procédé selon l'une quelconque des revendications 19 à 21, dans lequel ladite couche d'électrode de grille (3) est une couche de TaN, de TiN, ou de TaN/TiN.
